Europäisches Patentamt

European Patent Office

Office européen des brevets

(11) Veröffentlichungsnummer: **0 278 077**

**A2**

(12) # EUROPÄISCHE PATENTANMELDUNG

(21) Anmeldenummer: **87117275.5**

(22) Anmeldetag: **24.11.87**

(51) Int. Cl.⁴: **H01L 23/36**

(30) Priorität: **10.02.87 DE 8701989 U**

(43) Veröffentlichungstag der Anmeldung:
**17.08.88 Patentblatt 88/33**

(84) Benannte Vertragsstaaten:
**CH DE GB LI NL**

(71) Anmelder: **ANT Nachrichtentechnik GmbH**
**Gerberstrasse 33**
**D-7150 Backnang(DE)**

(72) Erfinder: **Berger, Erwin**
**Waldenburger Strasse 15**
**D-3340 Wolfenbüttel(DE)**

(54) **Baugruppe mit temperaturempfindlichen elektrischen Bauelementen.**

(57)
    1.  Baugruppe  mit  temperaturempfindlichen elektrischen Bauelementen.

    2.1.  Bei  bekannten  Schaltungsanordnungen mit temperaturempfindlichen elektrischen Bauelementen, die sich im thermischen Kontakt mit einem gemeinsamen Isothermkörper befinden, treten noch unerwünschte Temperatureinflüsse auf, die vermindert werden sollen.

    2.2. Es werden oberflächenmontierte Bauelemente (TS2, TS4) auf einer Leiterfolie (5) verwendet, die zwischen zwei Isothermkörpern (8, 9) angeordnet sind, welche sich auf jeweils einer Seite der Folie (5) befinden.

    2.3. Die Baugruppe kann als Modul beispielsweise in spannungsgesteuerten Verstärkern angewendet werden.

    3. Fig. 1.

Fig.1

EP 0 278 077 A2

## Baugruppe mit temperaturempfindlichen elektrischen Bauelementen

Die Neuerung bezieht sich auf eine Baugruppe mit temperaturempfindlichen elektrischen Bauelementen, die auf einem Isolierträger mit Leiterbahnen angeordnet sind und sich im thermischen Kontakt mit wenigstens einem Isothermkörper befinden. Eine solche Baugruppe kann beispielswiese als Modul Teil eines spannungsgesteuerten Verstärkers (VCA) sein, bei dem als temperaturempfindliche elektrische Bauelemente die Transistoren in Betracht kommen, deren Verstärkung durch eine Spannung gesteuert wird.

Bisher wurden die temperaturempfindlichen Bauelemente offen auf einer Leiterplatte an eine Isothermischiene angedrückt eingebaut. Auf diese Weise sollten die Temperaturen dieser Bauelemente untereinander gleich gehalten werden. Dies ist aber anscheinend nicht immer gelungen, wie temperaturabhängige Klirrfaktorwerte gezeigt haben.

Es ist Aufgabe der Neuerung, die Einflüsse unterschiedlicher Temperaturen und von Temperaturänderungen auf eine Baugruppe mit temperaturempfindlichen elektrischen Bauelementen zu vermindern.

Diese Aufgabe wird gelöst durch die Baugruppe mit den Merkmalen des Schutzanspruches 1. Vorteilhafte Weiterbildungen sind in den Unteransprüchen angegeben.

Der Kern der Neuerung besteht darin, daß oberflächenmontierte Bauelemente auf einer Leiterfolie und mit dieser zusammen zwischen zwei Isothermkörpern angeordnet sind, welche sich also auf jeweils einer Seite der Folie befinden.

Anhand des in der Zeichnung dargestellten Ausführungsbeispieles wird die Neuerung näher erläutert.

Fig. 1 zeigt einen Querschnitt durch eine Baugruppe, vergrößert im Maßstab 5:1.

Fig. 2 zeigt im Maßstab 4:1 eine Aufsicht auf eine ausgebreitete Folie, die als Isolierträger leicht zusammengefaltet in der Baugruppe nach Fig. 1 enthalten ist.

Fig. 3 stellt einen Längsschnitt durch die Folie nach Fig. 2 dar.

Fig. 4 zeigt, wie in einem Bauelement ein Transistor-oder Widerstands-Chip eingebettet ist.

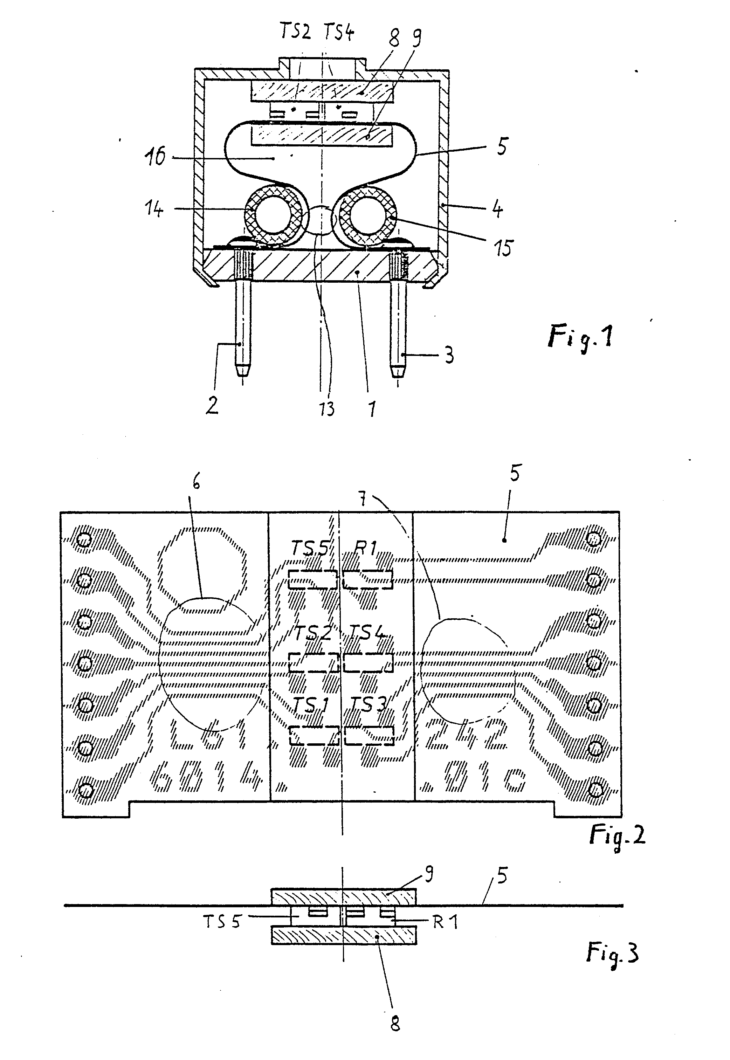

Die Baugruppe nach Fig. 1 weist eine Grundplatte 1 mit Anschlußstiften 2, 3 und eine wärmeisolierendes Gehäuse 4 auf. Innerhalb des Gehäuses führen die Anschlußstifte zu einer Folie 5 mit Leiterbahnen innerhalb der Ringmarkierungen 6, 7 (Fig. 2). Darauf sind als temperaturempfindliche elektrische Bauelemente Transistoren TS1 bis TS5 und ein Widerstand R1 zur Temperaturefassung als oberflächenmontierte Bauelemente aufgebracht und mit den Leiterbahnen elektrisch verbunden.

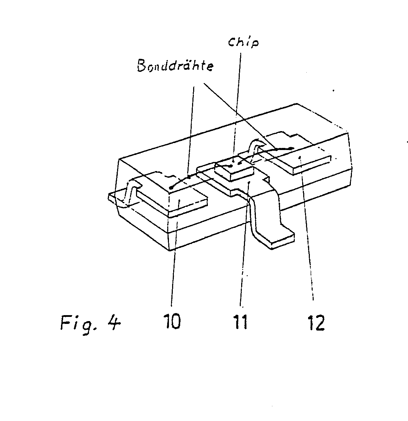

Um diese Bauelemente alle auf derselben Temperatur zu halten, ist im Wärmekontakt mit ihnen zunächst ein erster Isothermkörper 9 in Gestalt eines gut wärmeleitenden Metallplättchens (z.B. Kupfer, Aluminium oder ähnliches) vorgesehen. Es dient als Wärmeübertragungsmedium zwischen den Bauelementen und als Wärmekapazität und ist wärmeleitend unter die Folie 5 geklebt. Die Wärme fließt dabei durch die dünne Folie, die Bauteillötstellen und die Bauteilanschlüsse direkt in die Bauteile, denn die Transistor-bzw. Widerstands-Chips sind jeweils auf einem Bauteil-Anschluß 10, 11, 12 befestigt (Fig. 4), so daß eine gute Wärmekopplung gegeben ist.

Auf den Bauelementen TS1 bis TS5, R1 ist ein zweiter Isothermkörper 8 mit wärmeleitendem Kleber aufgeklebt und dient als zusätzliches Wärmeleitmedium und Wärmekapazität. Da er innen am Gehäuse 4 anliegt, soll er von außen über das Gehäuse 4 kommende Temperaturdifferenzen ausgleichen.

Die Isothermkörper 8 und 9 können im Bedarfsfall zur weiteren Verbesserung des Wärmeausgleiches wärmeleitend miteinander verbunden sein, wenn der fertigungstechnische Aufwand dafür nicht gescheut wird. Außerdem kann der Raum 16 in stärkerem Maße als gezeigt durch den Isothermkörper 9 ausgefüllt sein, so daß die Folie 5 mit einer noch größeren Fläche auf dem Isothermkörper 9 aufliegt.

Damit Temperaturdifferenzen, die über die Anschlußstifte 2, 3 ins Gehäuse 4 kommen, schon weitgehend ausgeglichen werden, bevor sie zum Isothermkörper 9 gelangen, sind die Leitungen bei 6 und 7 räumlich eng beieinander geführt. Zusätzlich sind die Leitungen bei 13 durch die zu einer Ω-förmigen Schlaufe gefaltete Folie 5 unter dem Isothermkörper 9 nah zueinander gebracht. Isolierschlauchstücke 14 und 15 sorgen dafür, daß die Folie mit ihrer Leiterbahnenseite nicht auf die Anschlußstifte herabsinkt, wodurch Kurzschlüße entstehen könnten.

Die gezeigte Baugruppe kann Teil eines spannungsgesteuerten Verstärkers sein, in welchem die Transistoren TS1 bis TS4 der Verstärkungssteuerung dienen, während mit dem Widerstand R1 die Temperatur erfaßt wird und mit dem Transistor TS5 eine Nachregelung elektrischer Werte in der Schaltung erfolgt.

Mit dem gezeigten Ausführungsbeispiel läßt sich erreichen, daß Temperatureinflüsse, die über die bislang vorhandenen Anschlußdrähte in die Bauelemente gelangen konnten, vermieden werden; zusätzlich sind auch die Einflüsse durch Temperaturunterschiede auf zuführenden Leiterbahnen vermindert. Auch eine unterschiedliche Wärmezufuhr über die Anschlußstifte 2 und 3 bleibt weitgehend ohne Einfluß auf die Bauelemente. Andere von außen auftretende unterschiedliche Temperaturen werden durch das wärmeisolierende Gehäuse 4 aus Kunststoff stark unterdrückt.

**Ansprüche**

1. Baugruppe mit temperaturempfindlichen elektrischen Bauelementen, die auf einem Isolierträger mit Leiterbahnen angeordnet sind und sich im thermischen Kontakt mit wenigstens einem Isothermkörper befinden, gekennzeichnet durch folgende Merkmale:
    a) Der Isolierträger ist eine Folie (5),
    b) die Bauelemente (TS1 bis TS5, R1) sind auf einer Seite der Folie (5) oberflächenmontiert, während auf der anderen Seite der Isothermkörper (9) wärmeleitend angeordnet ist,
    (c) auf die Bauelemente ist mit wärmeleitendem Kleber ein zweiter Isothermkörper (8) geklebt.

2. Baugruppe nach Anspruch 1, dadurch gekennzeichnet, daß die von den Bauelementen auf der folie (5) weggeführten Leiterbahnen zu beiden Seiten der Isothermkörper zu je einem Strang (6, 7) gebündelt sind.

3. Baugruppe nach Anspruch 2, dadurch gekennzeichnet, daß die Folie (5) als Schlaufe um einen der Isothermkörper (9) gelegt ist.

4. Baugruppe nach einem der vorangehenden Ansprüche, dadurch gekennzeichnet, daß sie sich in einem wärmeisolierenden Gehäuse (4) befindet.

5. Baugruppe nach einem der vorangehenden Ansprüche, dadurch gekennzeichnet, daß die beiden Isothermkörper (8, 9) wärmeleitend miteinander verbunden sind.

6. Baugruppe nach einem der vorangehenden Ansprüche, dadurch gekennzeichnet, daß sich unter den Bauelementen wenigstens ein zur Temperaturefassung dienedndes (R1) befindet.

7. Baugruppe nach einem der vorangehenden Ansprüche, dadurch gekennzeichnet, daß sich unter den Bauelementen Transistoren (TS1 bis TS5) befinden.

8.) Baugruppe nach einem der vorangehenden Ansprüche, dadurch gekennzeichnet, daß sie Teil eines spannungsgesteuerten Verstärkers ist.

Fig.1

Fig.2

Fig.3

Fig. 4    10    11    12